# Europäisches Patentamt

# European Patent Office

# Office européen des brevets

(11) Veröffentlichungsnummer: **0 104 685**
**B1**

(12) # EUROPÄISCHE PATENTSCHRIFT

(45) Veröffentlichungstag der Patentschrift:
08.02.89

(51) Int. Cl.⁴: **G 03 F 1/00**

(21) Anmeldenummer: 83201242.1

(22) Anmeldetag: 31.08.83

(54) Verfahren zur Herstellung einer Maske für die Musterzeugung in Lackschichten mittels Röntgenstrahllithographie.

(30) Priorität: 01.09.82 DE 3232499

(43) Veröffentlichungstag der Anmeldung:
04.04.84 Patentblatt 84/14

(45) Bekanntmachung des Hinweises auf die Patenterteilung:
08.02.89 Patentblatt 89/6

(84) Benannte Vertragsstaaten:
DE FR GB NL

(56) Entgegenhaltungen:
DE-A- 2 302 116
US-A- 4 357 417

FIJITSU, SCIENTIFIC AND TECHNICAL JOURNAL, Band 16, Nr. 4, Dezember 1980, Seiten 85-95, KAWASAKI, (JP) F. YAMAGISHI et al.: "Fabrication of silicon-polyimide complex X-ray mask".

(73) Patentinhaber: Philips Patentverwaltung GmbH,
Wendenstrasse 35 Postfach 10 51 49,
D-2000 Hamburg 1 (DE)

(84) Benannte Vertragsstaaten: DE

(73) Patentinhaber: N.V. Philips' Gloeilampenfabrieken,
Groenewoudseweg 1, NL-5621 BA Eindhoven (NL)

(84) Benannte Vertragsstaaten: FR GB NL

(72) Erfinder: Lentfer, Arno, Barmwisch 17,
D-2000 Hamburg 71 (DE)
Erfinder: Lüthje, Holger, Buchenweg 15,
D-2083 Halstenbek (DE)

(74) Vertreter: Nehmzow-David, Fritzi-Maria et al, Philips Patentverwaltung GmbH
Wendenstrasse 35 Postfach 10 51 49,
D-2000 Hamburg 1 (DE)

## Beschreibung

Die Erfindung betrifft ein Verfahren zur Herstellung einer Maske für die Mustererzeugung in Lackschichten mittels Röntgenstrahllithographie mit einer für Röntgenstrahlung weitgehend transparenten, unter Verwendung von Magnesium hergestellten Membran und einer, auf einer der Hauptflächen der Membran befindlichen, die Röntgenstrahlung absorbierenden, entsprechend dem zu erzeugenden Muster strukturierten Schicht.

Mit der Arbeit von E. Spiller und R. Feder «X-ray lithography» in «Topics in current physics: Y-ray optics» Springer, New York, 1977, Seiten 35 bis 92, wird gezeigt, welche Bedeutung die Röntgenstrahllithographie bei der Herstellung von z.B. Halbleitersystemen oder magnetischen Zylinderdomänenanordnungen hat, da insbesondere bei diesen Fertigungsprozessen zunehmend immer kleiner werdende Strukturen im μm- und nm-Bereich Bedeutung erlangen. Für alle Verfahren mit hoher Auflösung sind genaue und äusserst präzise definierte Masken erforderlich. Die Leistungsfähigkeit der Röntgenstrahllithographie wird deutlich an der minimalen Streifenbreite der Strukturen, die mit ihr zu erreichen ist: Lichtlithographie $\approx$ 2 bis 3 μm, Elektronenstrahllithographie $\approx$ 0,05 bis 0,1 μm, Röntgenstrahllithographie < 150 nm.

Die Anwendung von Röntgenstrahlen zur Belichtung eines zu strukturierenden Lackes bringt den Vorteil, dass störende Beugungserscheinungen bei der Projektion der Maskenstrukturen auf die Lackschicht herabgesetzt werden.

Für die Belichtung mit Röntgenstrahlen sind spezielle Bestrahlungsmasken zur Strukturerzeugung im Lack erforderlich; eine solche Maske besteht aus dem Muster der herzustellenden Struktur aus einem stark Röntgenstrahlen absorbierenden Material (im weiteren Absorber oder Absorbermuster genannt), wobei das Absorbermuster auf einer dünnen Membran aus einem für Röntgenstrahlen möglichst hochtransparenten Material angebracht ist.

Für den Absorber kommen Materialien mit einem möglichst hohen Atomgewicht in Betracht; in der Praxis bewährt haben sich z.B. Gold, Molybdän und Wolfram.

Als Material für die Membran kommen praktisch alle Materialien in Betracht, die hinlänglich transparent für Röntgenstrahlen sind. Da im Röntgenstrahlenbereich jedoch kein Material vollständig transparent und kein Material vollständig opak ist, sollte die Membran relativ dünn sein, um eine möglichst grosse Transparenz für Röntgenstrahlen zu gewährleisten, das Absorbermuster sollte dagegen relativ dick sein, um eine möglichst hohe Absorption von Röntgenstrahlen sicherzustellen.

Für die Herstellung der Membran sind bereits eine Reihe von Materialien untersucht worden. Es zeigten sich dabei die unterschiedlichsten Schwierigkeiten. In der Arbeit von Spiller und Feder a.a.O. wird eine Zusammenstellung von bisher für die Herstellung von Membranen für Röntgenstrahllithographie verwendeten Materialien genannt. Es kann zwischen anorganischen Materialien, wie Si, SiC, $Si_xN_y$, BN, $Al_2O_3$, Be, Ti oder organischen Materialien, wie z.B. Polyimid, Polycarbonat, Polyterephthalat, Polyäthylen unterschieden werden.

Es hat sich herausgestellt, dass Masken mit Membranen aus organischen Materialien zwar eine hohe Transparenz für Röntgenstrahlung und eine relativ hohe Bruchfestigkeit aufweisen; diese Materialien haben jedoch den Nachteil, dass sie schon unter normalen Umwelteinflüssen in ihrer Genauigkeit beeinträchtigt werden. Sie altern stark unter dem Einfluss von Röntgenstrahlung, und sie neigen dazu, sich bei höherer Luftfeuchtigkeit zu verziehen.

Die Masken mit Membranen aus den genannten anorganischen Materialien verändern sich mit Umwelteinflüssen nicht und bleiben massgenau, sind aber mit Ausnahme von Beryllium und Titan sehr empfindlich gegen Bruch und daher für eine Grossserienfertigung nicht optimal geeignet.

Gute Eigenschaften als Membranmaterial hat Titan; solche Membranen sind relativ bruchstabil und bleiben auch massgenau bei Temperatur- und Luftfeuchtigkeitsschwankungen. Hier besteht jedoch der Nachteil, dass die Produktionskosten für Titan ausserordentlich hoch sind. Abgesehen von den teuren Ausgangsmaterialien sind auch die erforderlichen Investitionen für die Herstellung von Titan so hoch, dass Titan ein relativ kostspieliges Material ist.

Wegen seiner toxischen Wirkung ist eine Verarbeitung von Be mit grossem Aufwand verbunden, so dass eine fabrikationsmässige Anwendung von Masken mit Beryllium-Membranen nicht ratsam erscheint.

Aus DE-A-2 302 116 ist ein Lithographieverfahren für die Vervielfältigung von Mustern mit submikronischen Strichstärken bekannt, bei dem über eine Maske aus Silicium mit einem Absorbermuster aus Gold eine für weiche Röntgenstrahlen empfindliche Schicht belichtet wird. Als mögliche Materialien für die Maske sind ausser Si noch Beryllium, Magnesium, Mylar, Aluminium und Polymerfilme genannt, es wird jedoch keine Lehre gegeben, wie derartige Masken hergestellt werden könnten.

Der Erfindung liegt die Aufgabe zugrunde, ein Verfahren für die Herstellung einer Maske für Röntgenstrahllithographie zu schaffen, bei dem Masken erhalten werden, die eine hohe Transparenz für Röntgenstrahlung haben, nicht bruchempfindlich sind, unter normalen Arbeitsbedingungen (also unter Einfluss von Röntgenstrahlen und erhöhter Luftfeuchtigkeit) ihre Massgenauigkeit behalten und die zudem vom Materialpreis her kostengünstig sind.

Diese Aufgabe wird erfindungsgemäss dadurch gelöst, dass die Membran dadurch gebildet wird, dass eine Schicht aus Magnesium auf einem für Röntgenstrahlung weitgehend transparenten Hilfsträger angebracht wird, der entweder im Maskenverbund verbleibt oder anschliessend entfernt wird.

Verbleibt der Hilfsträger im Maskenverbund, ergibt sich der Vorteil, dass für Röntgenstrahlung weitgehend transparente Membranen relativ grosser Abmessungen hergestellt werden können.

Nach einer weiteren vorteilhaften Ausgestaltung des Verfahrens nach der Erfindung wird als Hilfsträger eine Folie aus einem Kunststoff, insbesondere aus Polyimid oder Polycarbonat, eingesetzt. Hiermit ist der Vorteil verbunden, dass der Hilfsträger als Teil der Maske beibehalten werden kann, da beide Kunststoffe hoch transparent für Röntgenstrahlen und als Membranmaterial in Verbindung mit der ihre für eine Membrananwendung ungünstigen Eigenschaften kompensierenden Magnesiumschicht ausserordentlich gut geeignet sind. Ein weiterer Vorteil ist, dass mit einer derartigen Verbundmaske relativ grosse Membranen hergestellt werden können, die trotzdem ausserordentlich massgenau arbeiten, auch unter ungünstigen Umgebungsbedingungen.

Ein Hilfsträger in Form einer Folie aus Polyimid kann nach einer vorteilhaften Weiterbildung des erfindungsgemässen Verfahrens durch ein Plasmaätzverfahren in einem Sauerstoffplasma oder durch reaktive Ionenätzung in Sauerstoff entfernt werden. Hiermit ist der Vorteil verbunden, dass sich während des Ätzprozesses auf der Magnesiumschicht eine dünne Oxidschicht ausbildet, die die darunterliegende Magnesiumschicht nicht nur schützt sondern auch alterungsstabil macht.

Nach weiteren vorteilhaften Ausgestaltungen des Verfahrens nach der Erfindung wird als Hilfsträger eine Polycarbonatfolie eingesetzt, die durch einen Quellprozess in Dichlormethan entfernt werden kann.

Nach weiteren vorteilhaften Ausbildungen des Verfahrens nach der Erfindung wird als Hilfsträger ein Glassubstrat eingesetzt, auf dem zunächst eine an dem Substrat schlecht haftende, zusammenhängende Zwischenschicht und auf dieser die Magnesiumschicht angebracht wird, wobei die Zwischenschicht vorteilhafterweise als Mehrschichtenfolge angebracht werden kann, derart, dass auf dem Glassubstrat eine erste Schicht aus einem am Glassubstrat schlecht haftenden Material angebracht wird und auf dieser mindestens eine weitere Schicht aus einem Material, das als Diffusionssperre für das Material der ersten Schicht wirkt.

Werden nach Weiterbildungen des erfindungsgemässen Verfahrens für die erste Schicht Gold und für die weitere Schicht Titandioxid $TiO_2$ eingesetzt, ergeben sich mehrere Vorteile.

Die auf dem Glassubstrat angebrachte Mehrschichtenfolge kann ohne grosse Schwierigkeiten und ohne die Gefahr einer Beschädigung vom Substrat abgezogen werden, wobei die in der Mehrschichtenfolge vorhandene Goldschicht zwei Funktionen erfüllt: sie dient nicht nur dem leichten Ablösen der für die Herstellung der Maske zu verwendenden Mehrschichtenfolge vom Glassubstrat, weil sie an diesem schlecht haftet, sondern in einem folgenden Prozessschritt kann sie, in bekannter Weise z.B. durch Ionenätzen in Argon oder Argon/Sauerstoff, unter Ausbildung eines Absorbermusters strukturiert werden. Ist zwischen der Goldschicht und der Magnesiumschicht noch als weitere Schicht eine $TiO_2$-Schicht angebracht, erfüllt diese Schicht ebenfalls mehrere Funktionen: sie wirkt nicht nur als Diffusionssperre für Gold, sondern sie schützt die Magnesiumschicht gegen Alterungseinflüsse und gleicht mechanische Spannungen in der Magnesiumschicht aus.

Die mit dem Verfahren gemäss der Erfindung erzielbaren weiteren Vorteile bestehen insbesondere darin, dass eine für eine Grossserienfertigung hervorragend geeignete Maske für Röntgenstrahllithographie geschaffen ist, die die guten Eigenschaften der für derartige Membranen bekannten anorganischen Materialien mit den guten Eigenschaften der für den gleichen Zweck bekannten organischen Materialien verbindet, ohne deren jeweilige Nachteile zu zeigen. Durch die Anwendung von Magnesium für die Membran in Masken für Röntgenstrahllithographie werden diese Masken sehr kostengünstig; der Preis für Magnesium beträgt etwa $1/10$ des Preises für Titan. Ein weiterer Vorteil ist, dass Magnesium eine extrem hohe Durchlässigkeit für Röntgenstrahlung gerade im Bereich zwischen 1 und 4 nm hat. Wegen der im allgemeinen mit zunehmender Wellenlänge steigenden Lackempfindlichkeit einerseits und wegen der gerade noch vertretbaren Beugungserscheinungen andererseits ist insbesondere dieser Wellenlängenbereich für die Röntgenstrahllithographie von besonderem Interesse. Für Röntgenbelichtungsgeräte, die mit einem Kupfertarget arbeiten, ist eine Magnesiummembran besonders geeignet. In derartigen Geräten entsteht $CuK_\alpha$-Strahlung einer Wellenlänge $\lambda = 1{,}34$ nm. Eine Maske mit einer Magnesiummembran wäre aber auch für Belichtungsgeräte, die mit Synchrotronstrahlung arbeiten, gut geeignet.

Anhand der Zeichnung werden Ausführungsbeispiele der Erfindung beschrieben und in ihrer Wirkungsweise erläutert.

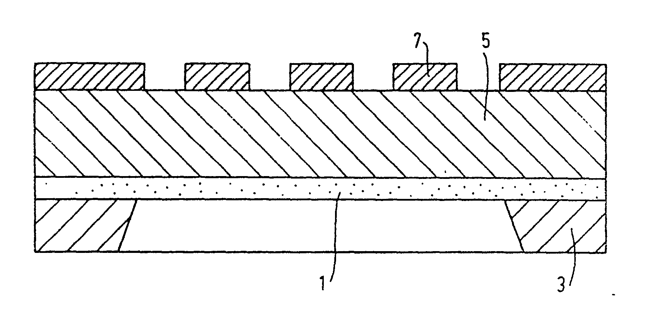

Fig. 1 zeigt eine Maske gemäss der Erfindung im Schnitt.

Zur Herstellung einer Maske mit einer Magnesiummembran können unterschiedliche Verfahren angewendet werden, die als Beispiele A bis E im einzelnen dargestellt werden.

Allen Verfahren gemeinsam ist, dass die Magnesiummembran in Form einer dünnen Schicht zunächst auf einem Hilfsträger abgeschieden wird, der anschliessend entfernt wird oder aber auch erhalten bleibt, wenn ein geeignetes Material für den Hilfsträger eingesetzt wird.

Verfahren A

Auf einem Hilfsträger 1 aus einem Kunststoff, z.B. auf einer Polyimidfolie, die auf einen Trägerring 3 geklebt und gespannt ist, wird eine Magnesiumschicht 5 durch Kathodenzerstäubung mit folgenden Parametern angebracht:

| | |
|---|---|
| HF-Generator | 13,6 MHz |
| Elektrodendurchmesser | 200 mm |

| Abstand der Elektroden | 45 mm |
| Arbeitsdruck der Gasatmosphäre (Ar) | 25 µbar |
| Potential an der Kathode | 600 V. |

Es wurden Magnesiumschichten einer Dicke von 1 bis 2 µm hergestellt; die Dicke der Schicht hängt von der Dauer des Kathodenzerstäubungsprozesses ab und kann entsprechend eingestellt werden.

Die auf diese Weise hergestellte Magnesium-Polyimid-Verbundmembran zeigt eine hervorragende Bruchstabilität und behält ihre Massgenauigkeit auch unter Einflüssen, die eine lediglich aus Polyimid bestehende Membran beeinträchtigt hätten. Es wurden Membranen mit einem Durchmesser bis zu 60 mm hergestellt, mit diesem Wert ist die Grenze der Möglichkeiten jedoch noch nicht erreicht. In der Figur ist auf der als Membran vorgesehenen Magnesiumschicht 5 ein Absorbermuster 7 dargestellt. Der Hilfsträger 1 kann entweder als Bestandteil der Maske beibehalten werden (dieser Fall ist in der Figur dargestellt), er kann jedoch auch, wie in den Verfahren B bis E beschrieben wird, entfernt werden, so dass dann freitragende, nur aus der Magnesiumschicht 5 bestehende Membranen vorliegen.

Verfahren B

Um eine freitragende Magnesiummembran herzustellen, kann so verfahren werden, dass eine Magnesiumschicht, wie unter Verfahren A beschrieben, zunächst auf einer Polyimidfolie abgeschieden wird und dass die Polyimidfolie in einem anschliessenden Ätzprozess von der Magnesiumschicht entfernt wird. Die Polyimidfolie kann entweder durch ein Plasmaätzverfahren in einem Sauerstoffplasma abgetragen werden oder durch reaktive Ionenätzung z.B. mit folgenden Parametern:

| HF-Generator | 27,25 MHz |
| Elektrodendurchmesser | 200 mm |
| Potential an der Kathode | 100 V |
| Arbeitsdruck der Gasatmosphäre (O₂) | 150 µbar |

Der Ätzprozess wirkt selektiv, so dass die Magnesiumschicht aufgrund der sich auf ihr ausbildenden definierten MgO-Schicht kaum angegriffen wird. Die freitragende Mg-Membran wird bereits durch eine wenige 10 nm dicke MgO-Oberflächenschicht stabilisiert.

Es wurden auf die beschriebene Weise Mg-Membranen mit einem Durchmesser von 1,5 cm und einer Dicke von 1,0 µm hergestellt; auch diese Werte stellen nicht die obere Grenze dar.

Verfahren C

Anstelle einer Polyimidfolie, wie unter Verfahren A beschrieben, kann eine Polycarbonatfolie als Hilfsträger für die Abscheidung der Magnesiumschicht eingesetzt werden. Soll eine freitragende Mg-Membran aus der abgeschiedenen Magnesiumschicht gebildet werden, kann die Polycarbonatfolie in einem Quellprozess entfernt werden. Als Quell- und Ablösungsmittel kann Dichlormethan eingesetzt werden.

Verfahren D

Eine freitragende Mg-Membran kann auch mit folgenden Verfahrensschritten hergestellt werden:

Auf einem Hilfsträger in Form einer Glasplatte, deren Oberfläche eine geringe Rauhigkeit im Bereich sowohl kurzwelliger als auch langwelliger Strahlung aufweist, wird mittels Kathodenzerstäubung eine < 50 nm dicke Goldschicht angebracht. Der Arbeitsdruck der Gasatmosphäre aus Argon beträgt dabei zweckmässigerweise 12 µbar bei einer Leistung von 125 W. Auf diese Goldschicht wird eine TiO₂-Schicht durch Kathodenzerstäubung aufgebracht bei einem Arbeitsdruck der Gasatmosphäre aus O₂ von 12 µbar und einer Leistung von 125 W. Diese TiO₂-Schicht wirkt als Diffusionssperre. Anschliessend wird auf die TiO₂-Schicht eine Mg-Schicht aufgebracht durch Kathodenzerstäubung, wie unter Verfahren A beschrieben. Die auf der Glasplatte schlecht haftende Goldschicht ermöglicht das Abziehen der Au/TiO₂/Mg-Schicht von der Glasplatte; zu diesem Zweck wird auf die abzuziehende Schicht ein Hilfsrahmen aufgeklebt. Zur Unterstützung des Ablösevorganges kann die beschichtete Glasplatte in ein Bad aus z.B. Glycerin oder einem Glykol getaucht werden. Die abgelöste Mg-Membran kann anschliessend in gewünschter Weise gespannt und auf einen Rahmen, z.B. aus Glas, geklebt werden. Auf diese Weise wurden Membranen eines Durchmessers von 90 mm realisiert, dieser Wert stellt aber keine Grenze nach oben dar. Die Dicke der auf diese Weise hergestellten Membranen lag im Bereich von 1,8 bis 2,2 nm, was aber nicht die erreichbare untere Grenze darstellt.

Verfahren E

Um den unter Verfahren D beschriebenen Ablöseprozess effektiver zu machen, d.h., um die Ausbeute an brauchbaren Membranen zu erhöhen, kann die Mg-Schicht zusätzlich mit einer etwa 2 µm dicken Lackschicht, z.B. aus einem im Handel erhältlichen Photolack, stabiler gemacht werden. Die Photolackschicht wird anschliessend durch einen Ätzschritt, z.B. durch Ätzung mittels Kathodenzerstäubung in einem Sauerstoffplasma, entfernt.

Membranen aus Magnesium sind für sichtbares Licht undurchlässig. Um direkte Justierprozesse mittels Laserstrahlen zu ermöglichen, ist es daher zweckmässig, Justierfenster in der Membran vorzusehen, die aus einem für sichtbares Licht transparenten Material, z.B. aus Polyimid, bestehen.

Auf den nach den Verfahren A bis E hergestellten Membranen wird anschliessend das Absorbermuster ausgebildet. Als sehr geeignet haben sich hierfür mehrschichtige Absorberschichten, z.B. aus Wolfram und Molybdän, erwiesen.

Hierzu kann wie folgt verfahren werden:

Sowohl die Wolfram- als auch die Molybdänschicht werden durch Kathodenzerstäubung angebracht. Die Wolframschicht wird zweckmässigerweise mit folgenden Parametern hergestellt:

| | |
|---|---|
| HF-Generator | 13,6 MHz; |
| Elektrodendurchmesser | 200 mm; |
| Abstand der Elektroden | 42 mm; |
| Arbeitsdruck der Gasatmosphäre (Ar) | 2 Pa; |
| Potential an der Elektrode | 800 V; |
| Potential am Maskenträger | 40 V. |

Die Molybdänschicht kann durch Kathodenzerstäubung unter folgenden Bedingungen angebracht werden:

| | |
|---|---|
| HF-Generator | 13,6 MHz; |
| Elektrodendurchmesser | 200 mm; |
| Abstand der Elektroden | 42 mm; |
| Arbeitsdruck der Gasatmosphäre (Ar) | 2 Pa; |
| Potential an der Elektrode | 700 V; |
| Potential am Maskenträger | 95 V. |

Die Strukturierung dieser Absorberschicht gemäss dem gewünschten Maskenmuster kann mit Hilfe bekannter Techniken, z. B. mit Hilfe der Elektronenstrahllithographie, ausgeführt werden.

**Patentansprüche**

1. Verfahren zur Herstellung einer Maske für die Mustererzeugung in Lackschichten mittels Röntgenstrahllithographie mit einer für Röntgenstrahlung weitgehend transparenten, unter Verwendung von Magnesium hergestellten Membran und einer, auf einer der Hauptflächen der Membran befindlichen, die Röntgenstrahlung absorbierenden, entsprechend dem zu erzeugenden Muster strukturierten Schicht, dadurch gekennzeichnet, dass die Membran dadurch gebildet wird, dass eine Schicht aus Magnesium auf einem für Röntgenstrahlung weitgehend transparenten Hilfsträger angebracht wird, der entweder im Maskenverbund verbleibt oder anschliessend entfernt wird.

2. Verfahren nach Anspruch 1, dadurch gekennzeichnet, dass die Magnesiumschicht durch Kathodenzerstäubung hergestellt wird.

3. Verfahren nach den Ansprüchen 1 und 2, dadurch gekennzeichnet, dass als Hilfsträger eine Folie aus einem Kunststoff eingesetzt wird.

4. Verfahren nach Anspruch 3, dadurch gekennzeichnet, dass eine Polyimidfolie eingesetzt wird.

5. Verfahren nach Anspruch 4, dadurch gekennzeichnet, dass der Hilfsträger durch ein Plasmaätzverfahren in einem Sauerstoffplasma oder durch reaktive Ionenätzung in Sauerstoff entfernt wird.

6. Verfahren nach Anspruch 3, dadurch gekennzeichnet, dass eine Polycarbonatfolie eingesetzt wird.

7. Verfahren nach Anspruch 6, dadurch gekennzeichnet, dass der Hilfsträger durch einen Quellprozess in Dichlormethan entfernt wird.

8. Verfahren nach den Ansprüchen 1 und 2, dadurch gekennzeichnet, dass als Hilfsträger ein Glassubstrat eingesetzt wird.

9. Verfahren nach Anspruch 8, dadurch gekennzeichnet, dass auf dem Glassubstrat zunächst eine an dem Substrat schlecht haftende, zusammenhängende Zwischenschicht und auf dieser die Magnesiumschicht angebracht wird.

10. Verfahren nach Anspruch 9, dadurch gekennzeichnet, dass als Zwischenschicht eine Mehrschichtenfolge angebracht wird, derart, dass auf dem Glassubstrat eine erste Schicht aus einem am Glassubstrat schlecht haftenden Material angebracht wird und auf dieser mindestens eine weitere Schicht aus einem Material, das als Diffusionssperre für das Material der ersten Schicht wirkt.

11. Verfahren nach Anspruch 10, dadurch gekennzeichnet, dass für die erste Schicht Gold eingesetzt wird.

12. Verfahren nach den Ansprüchen 10 und 11, dadurch gekennzeichnet, dass für die weitere Schicht Titandioxid $TiO_2$ eingesetzt wird.

**Claims**

1. A method of manufacturing a mask for the production of patterns in lacquer layers by means of X-ray lithography comprising a diaphragm highly transparent to X-ray radiation and obtained with the use of magnesium and a layer present on one of the major surfaces of the diaphragm, absorbing the X-ray radiation and structured in accordance with the pattern to be produced, characterized in that the diaphragm is formed in that a layer of magnesium is provided on an auxiliary carrier, which is highly transparent to X-ray radiation and either remains in the composite mask or is subsequently removed.

2. A method as claimed in Claim 1, characterized in that the magnesium layer is formed by cathode sputtering.

3. A method as claimed in Claims 1 and 2, characterized in that as auxiliary carrier use is made of a foil of a synthetic material.

4. A method as claimed in Claim 3, characterized in that a polyimide foil is used.

5. A method as claimed in Claim 4, characterized in that the auxiliary carrier is removed by a plasma etching process in an oxygen plasma or by reactive ion etching in oxygen.

6. A method as claimed in Claim 3, characterized in that a polycarbonate foil is used.

7. A method as claimed in Claim 6, characterized in that the auxiliary carrier is removed by a swelling dichloromethane.

8. A method as claimed in Claims 1 and 2, characterized in that as auxiliary carrier use is made of a glass substrate.

9. A method as claimed in Claim 8, characterized in that first a coherent intermediate layer poorly adhering to the substrate is provided on the glass substrate and the magnesium layer is provided on this layer.

10. A method as claimed in Claim 9, characterized in that as intermediate layer use is made of a multilayer sequence, in such a manner that a first layer of a material poorly adhering to the glass substrate is provided on the glass substrate and at least one further layer of a material acting as a diffusion barrier for the material of the first layer is provided on this layer.

11. A method as claimed in Claim 10, characterized in that gold is used for the first layer.

12. A method as claimed in Claims 10 and 11, characterized in that titanium dioxide ($TiO_2$) is used for the further layer.

**Revendications**

1. Procédé de fabrication d'un masque pour former par lithographie par rayons X des motifs dans des couches de laque, masque qui comporte une membrane sensiblement transparente au rayonnement X et réalisée à partir de magnésium ainsi qu'une couche située sur l'une des surfaces principales de la membrane et absorbant le rayonnement X, couche qui est structurée selon les motifs à former, caractérisé en ce qu'on réalise la membrane en formant une couche de magnésium sur un support auxiliaire très transparent au rayonnement X, support qu'on laisse subsister dans la structure du masque ou qu'on élimine par la suite.

2. Procédé selon la revendication 1, caractérisé en ce qu'on réalise la couche de magnésium par pulvérisation cathodique.

3. Procédé selon l'une des revendications 1 et 2, caractérisé en ce qu'on utilise comme support auxiliaire une feuille en matière plastique.

4. Procédé selon la revendication 3, caractérisé en ce qu'on utilise une feuille de polyimide.

5. Procédé selon la revendication 4, caractérisé en ce qu'on élimine le support auxiliaire par un procédé d'attaque par plasma dans un plasma d'oxygène ou par attaque ionique réactive dans de l'oxygène.

6. Procédé selon la revendication 3, caractérisé en ce qu'on utilise une feuille de polycarbonate.

7. Procédé selon la revendication 6, caractérisé en ce qu'on élimine le support auxiliaire par un processus de gonflement dans du bichlormé-thane.

8. Procédé selon l'une des revendications 1 et 2, caractérisé en ce que, comme support auxiliaire, on utilise un substrat de verre.

9. Procédé selon la revendication 8, caractérisé en ce qu'on recouvre d'abord le substrat de verre d'une couche intermédiaire continue peu adhérente au substrat et en ce qu'on forme sur celle-ci la couche de magnésium.

10. Procédé selon la revendication 9, caractérisé en ce que, comme couche intermédiaire, on forme une structure multicouche en recouvrant le substrat de verre d'une première couche en matériau peu adhérent au substrat de verre et en recouvrant celle-ci d'au moins une autre couche en matériau faisant fonction de barrière à la diffusion pour le matériau de la première couche.

11. Procédé selon la revendication 10, caractérisé en ce qu'on utilise de l'or pour la première couche.

12. Procédé selon l'une des revendications 10 et 11, caractérisé en ce qu'on utilise du bioxyde de titane $TiO_2$ pour l'autre couche.